# EUROPEAN PATENT APPLICATION

(11) **EP 1 367 653 A1**
(43) Date of publication of application: **03.12.2003**
(21) Application number: 02380111.1
(22) Date of filing: 27.05.2002
(51) Int. Cl.: H01L 31/18, G02F 1/1343, G02F 1/1333

(54) **Method for preparing transparent and conducting sheets on polymers**

(71) Applicant: CENTRO DE INVESTIGACIONES ENERGETICAS MEDIOAMBIENTALES Y TECNOLOGICAS (C.I.E.M.A.T.), E-28040 Madrid (ES)
(72) Inventor: Herrero Rueda, José, 28027 Madrid (ES); Guillen Arqueros, Cecilia, 28027 Madrid (ES)
(74) Representative: Del Santo Abril, Natividad

(57) **Abstract**

A method is proposed for preparing transparent and conducting sheets on polymers. A vertical structure is formed stacked on a polymer base depositing a transparent coating of indium oxide doped with tin (ITO) to provide a suitable substrate for optoelectronic applications. The ITO electrode has a preferential crystalline orientation on the plane (111). The formation of this film improves the physical properties of the substrate, reaching a high transparency value, an average of close to 80% in the 400-1100 nm spectra range, and conductivity, σ > 10³ (Ωxcm)⁻¹. The ITO films manufactured by the method proposed do not require heating of the substrate during the preparation of the layer, or treatment after deposition, to obtain high optoelectronic quality. The use of a pre-treatment with plasma of the organic sheets lead to obtaining adherent films without damaging the polymer sheets.

## Description

### BACKGROUND TO THE INVENTION

This invention refers to the field of solid state electronics and, more specifically, to a process for forming transparent conducting films on polymers used as substrates for different optoelectronic devices, more particularly for photovoltaic solar cells. One purpose of this invention is to provide a film of indium oxide doped with tin, In₂O₃:Sn (ITO), with excellent optic and electric characteristics on a polymer film, which is suitable for use in organic electroluminescent devices (EL), panel plant screens (FPD), active matrix liquid crystal display devices (AMLCD), and photovoltaic solar cells (PV).

A large number of ITO film applications are related to their optic and electric properties. The visible transmittance of 80% or higher, and a laminar resistivity of 10 Ω/square or lower make ITO films an excellent candidate as transparent electrodes in liquid crystal devices, intensity attenuating glass and solar cells.

Organic EL devices need a material capable of injecting more load bearers in the light emitting layer, or the bearer and transport injection layer. Bearer injection materials also need to be transparent and electroconducting because in many arrangements, the light is issued from the substrate side. The main properties required for transparent conducting oxides (OCT), such as ITO, ZnO and SnO₂, for PV solar cells, are high values of transparency and conductivity, and these layers deposited on glass plates are used as substrates for different technologies.

As described by M. Fahland et al in "Low resistivity transparent electrodes for displays on polymer substrates", *Thin Solid Films,* Vol. 392, pages 334-337 (2001), some EL, FPD and AMLCD applications require the plastics as base substrates, since polymers are lighter in comparison to glass and do not break. Furthermore, the price of some polymers and the manipulation of polymer films tens of micrometres thick provide more advantages than similar sheets of glass. Finally, but no less important, with polymers it is possible to manufacture flexible devices that can be bent.

In relation to PV solar cells, the use of glass substrates for the production of photovoltaic modules has more or less the same disadvantages as described above. These disadvantages can determine the final yield of the industrial process during the manufacturing phase. The use of flexible polymer films as substrates for solar cells opening the way for roll-to-roll production, and also interesting new applications for this type of fine layer photovoltaic models on flexible substrates.

In the same context, there are certain technological difficulties for the preparation of TCOs on polymer substrates. These difficulties are worse oxygen and water permeability of the polymers compared with glass, and principally the extreme difficulty involved in producing ITO electrodes because the temperatures required to obtain low electric resistivity can not be applied to the polymer substrate. Concentrating on the preparation of ITO films, it has been attempted to reduce the resistivity of this material to the name level (1 Ω/square or less) as metals. To date, the lowest resistivity obtained with this material is approximately 10 Ω /square, even forming the thin film on a glass substrate under heated conditions. Some authors maintain that it is technically impossible to deposit ITO on plastics with characteristics similar to those obtained on glass, and that the technology is still emerging, Shigesato et al, "Early stages of ITO deposition on glass or polymer substrates", *Vacuum,* Vol. 59, pages 614-621 (2000).

Hiraishi et al, US patent 6.181.062 (January, 2001) have prepared transparent ITO electrodes on polyester (PET) by cathode sputtering in order to obtain diffuser plates on organic EL devices. Also, Takematsu et al, US patent 6.207.263 (March, 2001), have developed ITO films to produce FPD. Most of these applications do not require the ITO film to have high conductivity values or post-deposition treatments at over 100°C. Photovoltaic elements with high power conversion efficiency have also been manufactured, Murakami et al in US patent 6.184.458 (February, 2001), where a transparent and conducting ITO film acts as a superior electrode and anti-reflectant layer.

US patent 6.188.176 granted to Nakagaya et al, on February 13, 2001 is included here to show the importance, in terms of device stability and ITO conductivity, of producing ITO films in which the principal crystalline orientation plane is (222) preferably with a high (400)/(222) peak intensity ratio when analysed by X-ray diffraction. In general, ITO layers contain In₂O₃ and SnO₂ in a stecheometric composition, although the quantity of oxygen may more or less deviate. According to the process developed by Nakagaya, when the formula InOₓSnO_{y} represents ITO films, it is preferred that 1<x<2 and 1.6<y<2.5 for application as conducting layers in organic EL devices.

In another context, several methods are known to prepare polymer surfaces to depositing thin films by physical methods; plasma attack is one of them. It is also known that the bombardment of, for example, a PET surface with ions produces surface layers rich in carbon. The article by Eketessaby et al entitled "Changes in chemical states of PET films due to low and high energy oxygen beam", *Thin Solid Films,* Vol. 377-378, pages 793 to 797 (2000) is included here because of its description of the changes of PET surfaces by beams of oxygen ions. The greatest concern associated to plasma attack applied to polymer films is the control of the process, since the plasma ions can damage the surface of the film or the polymer, effects than can produce a non-adherent coating or even the carbonisation and evaporation of the organic substrates.

An important embodiment of this invention is the preparation of ITO/polymer substrates with low electric resistance, preserving other properties such as the high transparency and stability of the polymer film. It is usually maintained that ITO does not provide a good union with the organic materials and/or that it is not typically a good conductor (resistivity values over 100 Ω/square), principally due to the requirements for conditioning the organic substrate or the temperature at which the ITO films are produced. Therefore, the inventors have designed a process to deposit ITO films on organic sheets which, preserving the polymer film, leads to the deposition of adherent ITO films with high transparency and conductivity values.

US patent 6.127.004 describes a method for forming improved fluorocarbon layers on substrates coated with ITO for application in electroluminescent devices. The document does not detail the conditions in which the ITO layer is prepared, although it mentions the importance of a plasma treatment with oxygen on the ITO layer, before depositing the subsequent layers.

None of the processes described above provides plastic substrates with the high conductivity and transparency values desired in the manufacture of different optoelectronic devices. Therefore, it is desirable to provide a method for forming transparent and conducting films on polymer sheets.

### SUMMARY OF THE INVENTION

Therefore, one objective of this invention is to provide an improved method for forming a transparent and conducting film, ITO, on polymer substrates by magnetron type cathode sputtering, reducing or eliminating the heating of the substrate during the process.

According to this invention, the formation of an ITO film includes separate treatment of the polymer substrate and the later deposition of the conducting layer. The substrate is treated firstly by a plasma attack on the surface and in optimal conditions it is estimated that a suitable surface is formed for the growth of more oxygen-deficient ITO films on PET substrates. If required, other polymer films can be used as substrates, such as Kapton KJ® . The indium-tin oxide is deposited from a white tile adhered to a magnetron type cathode in sub-atmospheric pressure conditions in the presence of a plasma containing argon and oxygen. If required, a superior aluminium/nickel electrode can also be evaporated as the electric contact for the ITO/polymer samples.

In optimal conditions, ITO films on polymer substrates have a resistivity value as low as 4 Ω/square. We also contemplate here that ITO films on polymer substrates, prepared by the method proposed, have a (400)/(222) diffraction peak intensity ratio of up to 0.83.

### DESCRIPTION OF THE GRAPHS

It is easier to understand this invention by reading the following detailed description of the preferred embodiments with reference to the graphs attached, in which:
Figure 1 is a simplified flow diagram showing a process useful for forming a transparent and conducting film on a polymer sheet according to this invention.
Figure 2 is a transversal section view, not drawn to scale, of part of a typical transparent and conducting polymer/ITO device, built according to the embodiments of this invention.
Figure 3 is a diagram of a vacuum chamber in which the pre-treatment is applied to polymer sheets and ITO deposition takes place according to this invention; and
Figure 4 is a graphic representation of the X-ray diffraction diagrams of ITO films deposited on different substrates according to this invention.

### DESCRIPTION OF THE PREFERRED EMBODIMENTS

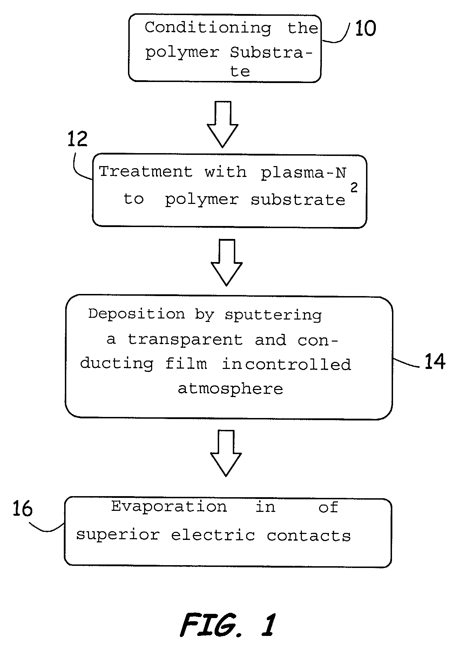

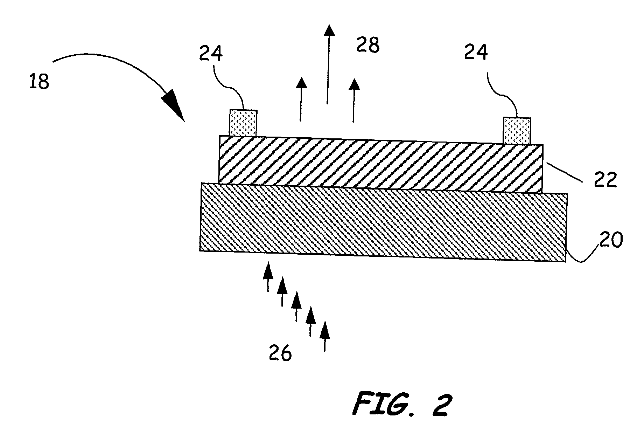

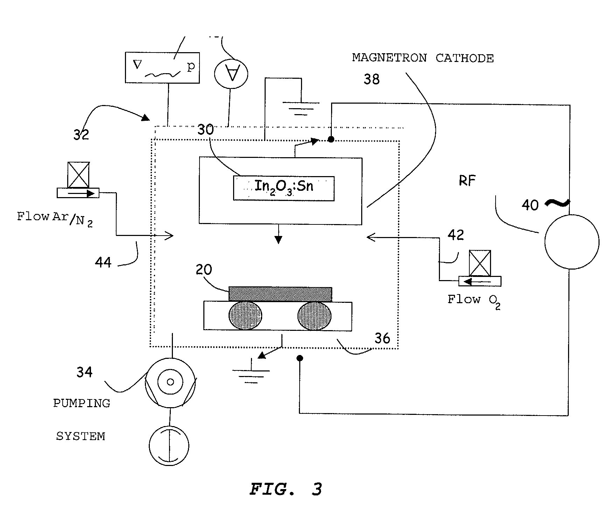

Referring now to figure 1, it illustrates a series of steps **10** to **16** to implant the process of this invention. In the context of the ITO/polymer device **18** in figure 2, step **10** implies conditioning the substrate before it is introduced into the vacuum chamber **32** in figure 3, step **10** is based on wet cleaning the sheet of plastic polymer and drying with air. The substrate **20** is a thermoplastic polymer sheet, for example polyethylene terephtalate (PET), or a polyimide polymer (Kapton KJ® ). The substrate **20** is a support material that has to be at least semi-transparent in the visible and/or solar spectra when the samples to be prepared using the method in this invention are to be used as substrates for flat panel displays or for photovoltaic applications.

As shown in figure 3, the sputtering cathode **30** is lodged in a high vacuum chamber **32** with pressure from 1x10⁻⁴ Pa to 2x10⁻³ Pa; a lower base pressure is preferred to reduce interaction with ambient gases, which is maintained by a turbomolecular pump system **34**. The samples are arranged on a base cooled by water **36**, placed in the vacuum chamber before evacuating the system. The sputtering target **30** consists of 5% of SnO₂ and 95% of In₂O₃ in weight, with a purity of 99.9. The target **30** has a diameter of three inches with a thickness of 6 mm. The target **30** is adhered with a vacuum epoxy resin to a copper back plate. The copper back plate is cooled with water to prevent the target from overheating and cracking; The mission of the copper plate is to support the target **30** lodging the magnets, and it acts as a cathode **38.** The target **30** and the sample holder **36** can be connected to a source of power **40** which by means of an impedance adaptation grid can apply up to a maximum output power of 1500 W, operating at 13.56 MHz. Any source of supply providing at least 200 W is sufficient. The target is placed approximately 10 cm above the sample using a rotating target holder. The cathode sputtering gases are argon (Ar) (99,9995 pure), oxygen (O₂) (99,999 pure) and nitrogen (N₂) (99.95 pure). The glass flow inside the chamber is recorded by individual mass flow controllers for O₂ **42** and Ar **44**. Thermocouples and Penning devices **46** monitor the temperature and pressure inside the vacuum chamber.

When the substrate **20** is conditioned, it is introduced into the vacuum chamber **32** for the surface treatment **12**, surface that is used for the deposition of a transparent and conducting film **14**. Pre-treatment of the substrate **12** begins after base pressure is reached, proceeding as follows:
- Connect the substrate holder **36** to the source of supply **40**.
- Adjust the nitrogen gas flow (N₂) in the vacuum chamber **32**. Operating pressure is not critical, although a vacuum of 1-2 Pa is preferred, which is sufficient to ignite the plasma.
- Switch on the source of supply **40**. This is when the nitrogen plasma should ignite. The power input applied is preferably approximately 0.4 to 2.5 W/cm², more preferably 1.5 to 2 W/cm². The upper limit is not so strict, although high power involves the risk of damaging the polymer sheets used.
- At the end of the plasma treatment time, the power input is slowly decreased **40** until the plasma is extinguished. The time of the plasma attack is not critical and it is preferably from 10 to 60 s, more preferably from 20 to 40 s, and even more preferably approximately 30 s. Again, long exposure of the polymer films to the nitrogen plasma could damage their structure or even completely destroy the organic support.

It has to be mentioned that an important embodiment of this invention is the use of nitrogen gas (N₂) to form the attack plasma, thus preventing the underlying polymer sheet from being damaged. The plasma gas is critical, the use of another inert gas such as argon (Ar) or the addition of oxygen (O₂) to form different plasma mixes during the attack process leads to the ITO films losing adherence or extreme damage to the polymer sheets.

During the plasma treatment, the substrate is maintained preferably at a temperature of approximately 25 to 30 °C by a water cooling circuit in the substrate holder. Too high temperature can damage the organic substrates.

After the treatment with nitrogen plasma, the sample is kept in the substrate holder **36** in the vacuum chamber **32**, and it is emptied to base pressure, 10⁻⁴ Pa or less. Note that the entire ITO electrode formation process on the polymer substrate is better without disturbing the vacuum between the surface treatment stages and cathode sputtering deposition.

An indium-tin oxide (ITO) film **22** is then deposited on the uncovered side of the polymer sheet. The deposition system is figure 3 is operated to deposit the ITO film as follows:
- Ground the substrate holder **36**, maintaining it cooled with water.
- Position the sputtering cathode and the target **30** over the sample **20**.
- Connect the magnetron cathode **30** to the source of supply.
   Adjust the oxygen gas flow (O₂) in the vacuum chamber **42**. The partial oxygen pressure is preferably approximately 1x10⁻³ to 1x10⁻² Pa, and more preferably 5x10⁻³ to 8x10⁻³ Pa.
- Adjust the argon (Ar) gas in the vacuum chamber until a pressure is maintained of preferably 5x10⁻¹ to 8×10⁻¹ Pa. In the following examples, these pressures should be sufficient to maintain the sputtering plasma.
- Switch on the source of supply **40**. The power input is preferably from 3 to 4.5 W/cm², and more preferably from approximately 3.8 to 4.3 W/cm². A higher sputtering power can be permitted if the O₂/Ar ratio in the chamber is altered. The plasma must be ignited under the previously described conditions.
- Maintain total pressure approximately between 5x10⁻¹ and 8x10⁻¹ Pa, and the power input as indicated above, during the cathode sputtering deposition process. The process time depends on the final thickness required for the ITO film. The final thickness of the ITO electrode is a compromise between the electric resistivity and light transmission required. Deposition speed is approximately 1 to 1.4 nm/s.
- When final ITO thickness is reached, the input power is slowly reduced **40** until the plasma is extinguished.

One embodiment of this invention is the development of a process in which heating is not applied to the substrate. Note that operating at ambient temperature with the polymer substrates used for the ITO deposition, using a substrate holder cooled by water, has two evident consequences, firstly avoiding the damage caused to the organic material by undesired heating; and secondly, being a more economic process.

After the ITO film is formed, electric contacts **24** are arranged on the ITO layer **22** in order to apply a polarisation voltage and/or extract electric current. The formation of these electric contacts **24** is preferably executed in one stage. These electric contacts can be aluminium, nickel, platinum, silver or a combination such as Al/Ni. They are prepared by evaporation or other suitable metal deposition techniques, after disguising the rest of the sample.

We will now describe this invention in more detail, referring to the properties of the ITO electrode obtained on three different substrates: calcium and sodium glass, PET and Kapton KJ®. We now describe experiments to illustrate this invention. Transparency T is the ratio between the light reaching **26** the substrate **18** in figure 2 and the light **28** crossing the substrate at a certain wavelength.

### EXAMPLES

Sodium and calcium glass, PET and Kapton KJ substrates were placed® (size 40x40 mm²) in the vacuum chamber described above, and the process of this invention was executed as proposed. Special care was taken to avoid undesired heating of the samples during the film deposition process. Thin films of ITO were deposited, with a thickness of over 500 nm, thickness determined on glass substrates, as references, with profilometric measurements. The ITO films thus obtained were analysed by the X-ray photoelectronic spectroscopy (XPS) method with a Perkin Elmer Phi 5400 ESCA system. The samples were excited with a Mg Kα (hν= 1253.6 eV) X-ray source operating with an input of 300 W. Surface analyses were performed at a base pressure of 10⁻⁹ Pa, on a 1 mm² surface area. Peak deconvolution and assignation was established according to the data available in the Perkin Elmer XPS Manual and the referenced bibliography. Atomic composition was determined from the typical XPS peaks, by evaluation of the peak areas weighted by the sensitivity factors of each element. On glass substrates, the final composition was 18% at. In, in which 92% corresponds to In₂O₃; and 1% at. Sn, 100% of which corresponds to SnO₂, and the rest of the composition of the film was determined as atmospheric carbon and oxygen contamination. For the ITO film on PET, the composition was 36% at. In, 95% of In₂O₃, and 2% at. Sn, 100% SnO₂. Table 1 shows a summary of the deconvolution and quantification data corresponding to the XPS spectra of thin ITO films, produced by cathode sputtering on glass and PET substrates. Note that the main difference between both samples can be determined by the presence or more quantity of In(OH)₃ on glass samples and the greater relative proportion of the O⁼ peak on PET substrates.

**TABLE 1**

| Sample | XPS chemical analysis | | | | |
|---|---|---|---|---|---|
| Glass/ITO | 55% C | 26% O | 18% In | | 1% Sn |
| | | 64% O⁼ | 92% In₂O₃ | 8% In(OH)₃ | 100% SnO₂ |
| PET/ITO | 18% C | 44% O | 36% In | | 2% Sn |
| | | 73% O⁼ | 95% In₂O₃ | 5% In(OH)₃ | 100% SnO₂ |

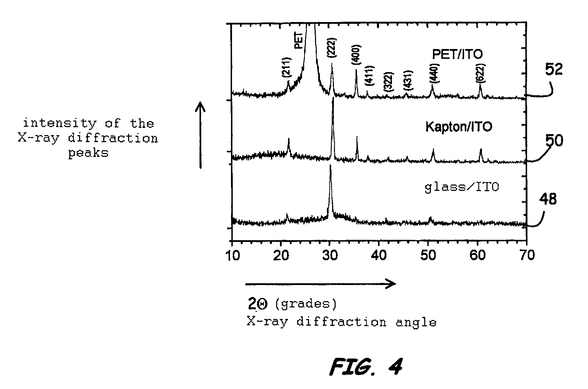

These ITO films on different substrates were analysed by the X-ray diffraction method (XRD). Measuring conditions included using the copper emission line K_{α1} filtered by nickel (λ= 1,5405 Å), metering range (2Θ) from 10° to 70°. The diffraction angles of the peaks (2Θ) observed in the XRD diagrams were converted into interplanar distances *d* and the identification of the phases present was thus carried out by comparing the interplanar distances *d* observed with the Powder Diffraction Pattern card archives (ASTM). The results appear in figure 4 for the Glass/ITO sample **48**, Kapton KJ®/ITO sample **50** and PET/ITO sample **52**; all the diffraction peaks are related to the In₂O₃ crystalline phase according to ASTM diffraction card number 6-416. The PET substrate also shows a wide diffraction peak at an angle 2Θ of approximately 26°. As can be seen on figure 4, all the samples show a preferential orientation on the plane (222). This orientation (222) is greater in the glass/ITO sample **48** than in the Kapton KJ®/ITO sample **50,** and the PET/ITO sample **52**.

Note that an important embodiment of this invention is the growth of polycrystalline ITO films on organic substrates without heating the polymer sheet, as shown by the XRD diagrams in figure 4.

As we said earlier, the increase of the (400)/(222) intensity ratio is directly related to an increase in the conductivity of the ITO film. Table 2 shows the (400)/(222) planes diffraction intensity ratio. It is observed that this ratio becomes increasingly prominent when using polymer films instead of glass as a substrate.

The optic transmittance on the 300-1500 nm wavelength range was measured for different samples. Table 2 presents the mean transparency (%), maximum transparency and minimum transparency for the spectra range from 400 to 1100 nm. Note that the best transparency values were determined on the polymer sheets.

**TABLE 2**

| Sample | (400)/(222) XRD intensity ratio | Transparency in the 400-1100 nm range | | | Laminar resistance (Ω /square) | Resistivity (Ωxcm) |
|---|---|---|---|---|---|---|
| | | Mean (%) | Maximum (%) | Minimum (%) | | |
| Glass/ITO | 0.03 | 69.3 | 79.3 | 37.3 | 40 | 2.50x1⁻³ |
| Kapton/ITO | 0.37 | 72.5 | 85.4 | 3.5 | 14 | 8.40x10⁻⁴ |
| PET/ITO | 0.83 | 77.8 | 84.3 | 47.7 | 4 | 2.45x10⁻⁴ |

Table 2 also shows the dependence of the electric properties, laminar resistance and resistivity of the ITO films on the substrate used. It can be seen that the laminar resistance of the ITO films changes considerably when using polymer films as substrates. Note that values as low as 4 Ω/square were determined using a PET base sheet.

A method has been described to prepare ITO films on organic substrates that have improved conductivity and transparency values in relation to the same layers on glass. This method can provide a conducting and transparent substrate for different applications in the optoelectronic industry. As a result of this invention it is possible to prepare ITO electrodes on polymer substrates with high transparency throughout the visible spectrum, thus providing a lightweight and flexible substrate for many applications in which the electric contacts have to be practically transparent.

The result of this invention provides a method capable of forming an ITO layer with a good union to the underlying organic layer. It is considered that ITO films on polymer sheets represent a priority embodiment for this invention, since they provide ITO/polymer substrates with high mechanical stability.

The invention has been described in detail with particular reference to priority embodiments, but it will be understood that variations and changes can be made within the scope and spirit of the invention.

## Claims

1. Method for preparing transparent and conducting sheets on polymers used as substrates for optoelectronic applications, consisting of a base polymer to deposit a thin film coating, substantially conducting and transparent, of indium oxide electrode doped with tin (ITO) applied to the surface of the polymer, on which electric contacts can be joined to said ITO layer to receive a polarisation voltage and/or extract electric current, **characterised in that** it consists of the following stages; conditioning polymer sheets; treating the polymer surface with nitrogen plasma; depositing said ITO electrodes by cathode sputtering; and, if required, vacuum evaporating the superior electric contacts.

2. Method according to claim 1, **characterised in that** said polymer sheets are polyethylene terephtalate (polyester or PET), and polyimide (Kapton KJ® ).

3. Method according to claim 1, **characterised in that** said treatment of the substrate with nitrogen plasma consists of the following steps: placing said polymer substrates in a substrate holder in a vacuum chamber at 1x10⁻⁴ Pa or less; connecting said substrate holder to a source of supply; establishing a nitrogen gas flow in said vacuum chamber, maintaining the pressure in the vacuum chamber at 2 Pa; establishing the power level for the ignition of the plasma in order to start the plasma attack on the exposed side of said polymer substrates; reducing the power level until the plasma is extinguished after the time required for the preparation of said exposed side of the polymer substrate.

4. Method according to claim 1, **characterised in that** the time established for said plasma attack on the substrate is approximately 20 seconds.

5. Method according to claim 1, **characterised in that** said deposition by cathode sputtering of said ITO electrodes consists of the following stages: leaving said substrates in the vacuum chamber in the substrate holder, again reducing the vacuum pressure to 1x10⁻⁴ Pa; positioning a cathode sputtering target over said substrate holder; connecting the sputtering target to the source of supply; establishing a flow of argon and oxygen gases inside the vacuum chamber, forming a reactive argon/oxygen atmosphere; maintaining the pressure in the vacuum chamber at 0.5 Pa; establishing the power level; igniting a plasma to start the cathode sputtering of the material of the target on the exposed side of the polymer substrates; reducing the power level until the plasma is extinguished after obtaining the thickness required for the ITO electrode on the polymer substrates.

6. Method according to claim 1, **characterised in that** the cathode sputtering target consists of a mix of indium oxides and tin in tablet form.

7. Method according to claim 1, **characterised in that** the mix of indium oxides and tin is formed by In₂O₃/SnO₂ in a ratio of 19/1.

8. Method according to claim 1, **characterised in that** the cathode sputtering process is established with a deposition speed of 1.2 nm/s for the ITO electrode.

9. Method according to claim 1, **characterised in that** the ITO electrode is prepared without heating the polymer sheets of claim 3.

10. Method according to claim 1, **characterised in that** the ITO film is prepared in reactive sputtering conditions, without damaging the polymer sheets of claim 2 in the reactive argon/oxygen atmosphere used.

11. Method according to claim 1, **characterised in that** the substrate has a light transmission of nearly 80 % in the 400-1100 nm spectra range.

12. Method according to claim 1, **characterised in that** the ITO electrode analysed by X-ray diffraction shows an intensity ratio of the principal (400)/(222) peaks of up to 0.83.

13. Method according to claim 1, **characterised in that** the ITO electrode on a polymer sheet base has a resistivity value as low as 4 Ω/square.
